# EUROPÄISCHE PATENTSCHRIFT

(11) **EP 3 475 824 B1**
(45) Veröffentlichungstag und Bekanntmachung des Hinweises auf die Patenterteilung: **30.08.2023**
(21) Anmeldenummer: 17746438.5
(22) Anmeldetag: 24.07.2017
(51) Int. Cl.: G06F 11/16

(54) **VERFAHREN UND VORRICHTUNG ZUR REDUNDANTEN DATENVERARBEITUNG**
METHOD AND APPARATUS FOR REDUNDANT DATA PROCESSING
PROCÉDÉ ET DISPOSITIF DE TRAITEMENT DE DONNÉES REDONDANT

(30) Priorität: 17.08.2016 DE 102016215345
(43) Veröffentlichungstag der Anmeldung: 01.05.2019
(73) Patentinhaber: Siemens Mobility GmbH, 81739 München (DE)
(72) Erfinder: ECKELMANN-WENDT, Uwe, 38302 Wolfenbüttel (DE); GERKEN, Stefan, 38116 Braunschweig (DE)
(74) Vertreter: Siemens Patent Attorneys
(86) Internationale Anmeldenummer: PCT/EP2017/068635
(87) Internationale Veröffentlichungsnummer: WO 2018/033344

(56) Entgegenhaltungen:
- EP-A2- 0 969 374
- WO-A2-2014/009243
- US-B1- 8 443 230
- ANDREA HÖLLER ET AL: "Patterns for automated software diversity to support security and reliability", PATTERN LANGUAGES OF PROGRAMS, ACM, 2 PENN PLAZA, SUITE 701 NEW YORK NY 10121-0701 USA, 8. Juli 2015 (2015-07-08), Seiten 1-13, XP058079545, DOI: 10.1145/2855321.2855360 ISBN: 978-1-4503-3847-9

## Beschreibung

Die Erfindung betrifft ein Verfahren und einen integrierten Schaltkreis zur redundanten Datenverarbeitung.

Sicherheitsrelevante Softwareanwendungen, beispielsweise Software zur Steuerung eines Stellwerks oder dergleichen, haben in der Regel besondere Sicherheitsanforderungen zu erfüllen, welche beispielsweise in den Sicherheitsnormen EN 61508 oder EN 50129 standardisiert sind.

Ein Merkmal sicherheitskritischer Software ist zumeist, dass zumindest Anteile einer Softwareanwendung redundant ausgeführt werden. Die Ergebnisse, die sich aus einer solchen redundanten Ausführung ergeben, werden dann verglichen. Werden Abweichungen zwischen einzelnen der Ergebnisse festgestellt, so liegt ein Fehler vor, beispielsweise ein Hardwarefehler, der auf diese Weise erkannt werden kann.

Zum redundanten nebenläufigen Ausführen von Softwareanwendungen können voneinander unabhängige Prozessoren verwendet werden. Der Aufwand liegt hier im hohen Materialeinsatz. Zusätzlich können Verfahren zum Synchronisieren der einzelnen Prozessoren notwendig werden. Beispielhaft kann hier die SIMIS-Technologie der Anmelderin angeführt werden.

Im Falle von speziellen sicherungstechnischen Prozessoren, wie beispielsweise so genannten Lockstep-Prozessoren, arbeiten zwei Prozessorkerne auf einem Prozessor so synchron, dass Rechenergebnisse der Prozessorkerne von einem Vergleichsbaustein auf dem Prozessor stetig verglichen und überwacht werden können. Im Falle einer Abweichung stoppt das System. In diesem Zusammenhang ist es erforderlich, dass die Software auf den beiden Prozessorkernen praktisch identisch abläuft.

Weiterhin besteht die Möglichkeit, Software und Daten mehrfach unterschiedlich zu codieren, damit gleichartige Hardwarefehler sich auf die Software nicht gleichartig auswirken. Ein Beispiel ist hier die FailSafe-Simatic-Lösung der Anmelderin. Der Aufwand besteht hierbei darin, dass identische Abläufe auf unterschiedliche Weise codiert werden müssen.

Schließlich besteht die Möglichkeit, ein paralleles redundantes Ausführen einer Softwareanwendung lediglich zu emulieren. Dazu wird beispielsweise ein softwarebasierter Emulator verwendet, der auf einem Prozessor ausführbar ist, und der eingerichtet ist, das Ausführen der Softwareanwendung auf verschiedenen Prozessoren zu emulieren. Dies hat den Vorteil, dass Hardware eingespart werden kann. Nachteilig an dieser Lösung ist die aufgrund der Emulation erhöhte Laufzeit.

Grundsätzlich ist es möglich, anstelle verschiedener Prozessoren zum redundanten, vorzugsweise nebenläufigen Ausführen einer Softwareanwendung verschiedene Prozessorkerne eines Mehrkernprozessors zu verwenden. Hierbei muss allerdings berücksichtigt werden, dass sich die Prozessorkerne eines Mehrkernprozessors zumindest einige Hardware-Ressourcen des Prozessors teilen, wie z. B. Daten- oder Steuerleitungen im Prozessor, Cachelines, Cachespeicher, etc. Die Prozessorkerne sind also nicht völlig unabhängig voneinander. Daher kann es vorkommen, dass ein auf den verschiedenen Prozessorkernen redundant ausgeführtes Nutzprogramme gleichartig oder sogar identisch auf solche Fehler reagiert, die von den von den verschiedenen Prozessorkernen gemeinsam genutzten Ressourcen herrühren. Man spricht in diesem Zusammenhang von "common cause" Fehlern. Ein Vergleich von auf unterschiedlichen Prozessorkernen eines Mehrkernprozessors redundant ausgeführter Software ist also im Falle von Fehlern in gemeinsam genutzten Hardwareressourcen nicht immer ausreichend, um Fehler dieser Hardwareressourcen zu erkennen.

Im Dokument WO 2014009243 A2 wird eine Anordnung mit einem Mikroprozessorsystem beschrieben, das so programmiert ist, dass eine redundante Datenverarbeitung durchgeführt wird, wobei das gleiche Nutzprogramm mindestens zweimal ausgeführt wird, und mit einem Vergleichsmodul, das die Ergebnisse der mindestens zwei Programmausführungsoperationen miteinander vergleicht. Das Mikroprozessorsystem ist ferner so programmiert, dass mindestens zwei der Emulatoren softwaremäßig unterschiedliche Mikroprozessoren auf diesem Mikroprozessorsystem emulieren.

Die Aufgabe der vorliegenden Erfindung besteht darin, den vorstehend genannten Nachteilen Rechnung zu tragen und eine Vorrichtung und ein Verfahren vorzuschlagen, welche es ermöglichen, verschiedene Prozessorkerne eines Mehrkernprozessors zum redundanten Ausführen einer sicherheitskritischen Anwendung heranzuziehen.

Erfindungsgemäß wird eine Anordnung zur redundanten Datenverarbeitung mit einem integrierten Schaltkreis zur Verfügung gestellt. In dem integrierten Schaltkreis ist die Funktionalität eines Mehrkernprozessors mit einer Mehrzahl von Prozessorkernen implementiert. Die Prozessorkerne sind jeweils ausgebildet, ein Nutzprogramm auszuführen. Die Anordnung umfasst weiterhin einen Vergleichsbaustein, der eingerichtet ist, Ergebnisse zu vergleichen, die sich aus einer Ausführung des Nutzprogramms durch jeweils verschiedene der Prozessorkerne ergeben. Ein erster Prozessorkern und ein von dem ersten Prozessorkern verschiedener zweiter Prozessorkern aus der Mehrzahl der Prozessorkerne sind in dem integrierten Schaltkreis derart implementiert, dass der erste Prozessorkern zum Abspeichern und Auslesen von Daten in oder aus einem dem ersten Prozessorkern zugeordneten ersten Speicherbereich gemäß einer ersten Alternative der Erfindung eine Adressstruktur verwendet, die sich von einer Adressstruktur unterscheidet, welche der zweite Prozessorkern zum Abspeichern und Auslesen von Daten in oder aus einem dem zweiten Prozessorkern zugeordneten zweiten Speicherbereich verwendet. Gemäß einer zweiten Alternative der Erfindung stattdessen oder gemäß einer dritten Alternative der Erfindung zusätzlich sind der erste Prozessorkern und der zweite Prozessorkern in dem integrierten Schaltkreis derart implementiert, dass der erste Prozessorkern zum Abspeichern und Auslesen von Daten in oder aus einem dem ersten Prozessorkern zugeordneten ersten Speicherbereich eine Datenstruktur verwendet, die sich von einer Datenstruktur unterscheidet, welche der zweite Prozessorkern zum Abspeichern und Auslesen von Daten in oder aus einem dem zweiten Prozessorkern zugeordneten zweiten Speicherbereich verwendet. Die Implementation des ersten Prozessorkerns in dem integrierten Schaltkreis ist hardwaremäßig von der Implementation des zweiten Prozessorkerns zumindest teilweise separiert.

Das erfindungsgemäße Verfahren zur redundanten Datenverarbeitung mittels einer Anordnung mit einem integrierten Schaltkreis umfasst die folgenden Schritte:
Ein Nutzprogramm wird durch einen ersten Prozessorkern und einen zweiten Prozessorkern eines durch den integrierten Schaltkreis implementierten Mehrkernprozessors ausgeführt.

Dann werden Ergebnisse verglichen, die sich aus der Ausführung des Nutzprogramms durch den ersten Prozessorkern und aus der Ausführung des Nutzprogramms durch den zweiten Prozessorkern ergeben. Dabei verwendet der erste Prozessorkern zum Abspeichern und Auslesen von Daten in oder aus einem dem ersten Prozessorkern zugeordneten ersten Speicherbereich gemäß der ersten Alternative der Erfindung eine Adressstruktur, die sich von einer Adressstruktur unterscheidet, welche der zweite Prozessorkern zum Abspeichern und Auslesen von Daten in oder aus einem dem zweiten Prozessorkern zugeordneten zweiten Speicherbereich verwendet. Gemäß der zweiten Alternative stattdessen oder gemäß der dritten Alternative zusätzlich verwendet der erste Prozessorkern zum Abspeichern und Auslesen von Daten in oder aus einem dem ersten Prozessorkern zugeordneten ersten Speicherbereich eine Datenstruktur, die sich von einer Datenstruktur unterscheidet, welche der zweite Prozessorkern zum Abspeichern und Auslesen von Daten in oder aus einem dem zweiten Prozessorkern zugeordneten zweiten Speicherbereich verwendet. Der erste Prozessorkern wird in dem integrierten Schaltkreis hardwaremäßig zumindest teilweise separat von dem zweiten Prozessorkern implementiert. Beispielsweise können Adressleitungen auf einen gemeinsam genutzten Speicher vom ersten Prozessorkern in anderer Reihenfolge aufgelegt werden als vom zweiten Prozessorkern. Dadurch ergibt sich automatisch eine Adressverwürfelung. Muster im Speicher, die durch Fehler repetierend entstehen, wirken dann bei beiden Kernen unterschiedlich. In analoger Weise kann man mit Datenzugriffen verfahren werden, indem Datenleitungen in unterschiedlicher Reihung auf beide Prozessorkerne aufgelegt werden. Es versteht sich, dass eine hardwaremäßige Implementierung der beiden Prozessorkerne beliebig komplizierte Daten- und/oder Adressverwürfelungen zulässt.

Es versteht sich, dass die Erfindung nicht auf einen ersten und einen zweiten Prozessorkern eines Mehrkernprozessors beschränkt ist. Im Falle eines Mehrkernprozessors mit mehr als zwei Prozessorkernen können sich diese Prozessorkerne paarweise zueinander so verhalten, wie es vorstehend mit Bezug auf den ersten Prozessorkern und den zweiten Prozessorkern beschrieben worden ist.

Die Erfindung bietet eine Reihe von Vorteilen, die nachfolgend erläutert werden.

Aufgrund der Tatsache, dass die einzelnen Prozessorkerne zum Abspeichern oder Auslesen von Daten in oder aus dem Prozessorkernen jeweils zugeordneten Speicherbereichen spezifische, den jeweiligen Prozessorkernen zugeordnete Adressstrukturen und/oder Datenstrukturen verwenden, können Fehler in solchen Ressourcen, die von verschiedenen Prozessorkernen gemeinsam genutzt werden, insbesondere in gemeinsam genutztem Speicher, aber auch gemeinsam genutzten Daten- oder Adressleitungen, erkannt werden. Dies liegt daran, dass sich Fehler, die auf einer Fehlfunktion einer dieser Ressourcen beruhen, in jedem der Prozessorkerne auf andere Weise bemerkbar machen, aufgrund der Verwendung der prozessorkernspezifischen Adressstruktur oder Datenstruktur.

Gemäß der ersten Alternative der Erfindung sind der erste Prozessorkern und der zweite Prozessorkern derart implementiert, dass der zweite Prozessorkern zum Abspeichern und Auslesen von Daten in oder aus dem zweiten Speicherbereich eine Adressstruktur verwendet, die im Vergleich zu einer seitens des ersten Prozessorkerns zum Abspeichern und Auslesen von Daten in oder aus dem ersten Speicherbereich verwendeten Adressstruktur transformiert ist. Die Art der Transformation kann variieren. Bevorzugt kann die Transformation durch eine Verwürfelung, d. h. eine in der Regel (pseudo)zufällige Permutation von Speicheradressen eines dem jeweiligen Prozessorkerns zugeordneten Speicherbereichs definiert sein.

Gemäß der zweiten Alternative stattdessen oder der dritten Alternative zusätzlich sind der erste Prozessorkern und der zweite Prozessorkern derart implementiert, dass der zweite Prozessorkern zum Abspeichern und Auslesen von Daten in oder aus dem zweiten Speicherbereich eine Datenstruktur verwendetet, die im Vergleich zu einer seitens des ersten Prozessorkerns zum Abspeichern und Auslesen von Daten in oder aus dem ersten Speicherbereich verwendeten Datenstruktur Datenwörter transformiert. Datenwörter können dabei insbesondere mittels Bitverschiebung transformiert werden. Andere arithmetische Operationen können zur Transformation eines zu speichernden/lesenden Datenworts ebenfalls herangezogen werden, beispielsweise eine Multiplikation mit einer Primzahl.

Insbesondere, um eine Datenkommunikation einer Softwareanwendung, die auf den jeweiligen Prozessorkernen ausgeführt wird, mit einer Instanz außerhalb des jeweiligen Prozessorkerns zu ermöglichen, kann gemäß einer Ausführungsform ein Ein- und Ausgabespeicherbereich vorgesehen sein. Daten, die in diesem Speicherbereich abgelegt werden, sollten hinsichtlich ihrer Adress- und Datenstruktur, die seitens eines der Prozessorkerne zum Abspeichern oder Auslesen von Daten in oder aus diesem Ein- und Ausgabespeicherbereich verwendet werden, einer vorgegebenen Adress- und Datenstruktur folgen, die auch der externen Instanz bekannt ist. Mit anderen Worten werden hier seitens der Prozessorkerne keine prozessorspezifisch transformierten Adress- oder Datenstrukturen verwendet.

Im Vergleich zur Verwendung einer Mehrzahl unabhängiger Prozessoren zum redundanten Ausführen des Nutzprogramms hat die vorliegende Erfindung den Vorteil, dass die Prozessorkerne des Mehrkernprozessors Hardwareressourcen des integrierten Schaltkreises gemeinsam verwenden können, wie z. B. Speicher, Daten- und Adressleitungen, etc. Dies führt zu einer verbesserten Effizienz der Gesamtberechnung. Mit anderen Worten ist gemäß einer bevorzugten Ausführungsform die Funktionalität des Mehrkernprozessors in dem integrierten Schaltkreis derart implementiert, dass der erste Prozessorkern und der zweite Prozessorkern eingerichtet sind, Hardwareressourcen des integrierten Schaltkreises gemeinsam zu verwenden.

Im Vergleich zu einer grundsätzlich möglichen, rein softwarebasierten Lösung, bei welcher die Funktionalität eines Mehrkernprozessors dadurch implementiert wird, dass ein Emulator die Prozessorkerne des Mehrkernprozessors softwaremäßig emuliert, bietet die vorliegende Erfindung eine Reihe weiterer Vorteile. Dadurch, dass zumindest ein Teil der Funktionalität des Mehrkernprozessors direkt in Hardware umgesetzt oder zumindest in Hardware konfiguriert wird, kann die redundante Berechnung des Nutzprogramms deutlich schneller ablaufen als in einem rein softwarebasierten Emulator. D. h. allein dadurch, dass die Implementation des ersten Prozessorkerns in dem integrierten Schaltkreis hardwaremäßig von der Implementation des zweiten Prozessorkerns zumindest teilweise separiert ist, d. h. die Funktionalität der Prozessorkerne zumindest teilweise in der Hardware direkt konfiguriert wird, ergeben sich Laufzeitgewinne.

Das letztgenannte Merkmal, wonach die Implementation des ersten Prozessorkerns in dem integrierten Schaltkreis hardwaremäßig von der Implementation des zweiten Prozessorkerns zumindest teilweise separiert ist, bietet weitere Vorteile. Durch dieses Merkmal kann erreicht werden, dass Anforderungen, die bei einer softwarebasierten Emulatorlösung erzwungen und überwacht werden müssen, insbesondere die Bindung einer vorgegebenen Funktionalität an einen spezifischen Prozessorkern, sich erfindungsgemäß quasi unmittelbar ergeben.

Erfindunggemäß ist die Funktionalität des Transformierens der Adressstruktur und/oder der Datenstruktur für den ersten Prozessorkern und den zweiten Prozessorkern in dem integrierten Schaltkreis hardwaremäßig separat implementiert. Eine Prüfung dahingehend, ob diese Funktionalitäten jeweils an den korrekten Prozessorkern gebunden sind, welche in einer Emulatorlösung notwendig wäre, kann gemäß dieser Ausführungsform entfallen.

Eine analoge Effizienzsteigerung ergibt sich im Zusammenhang mit einer Ausführungsform der Erfindung, wonach der erste Prozessorkern und der zweite Prozessorkern jeweils derart implementiert sind, dass sie eingerichtet sind, während der Laufzeit Daten zu erfassen, die einen Programmablauf beim Ausführen des Nutzprogramms beschreiben. Solche Daten sind insbesondere besuchte Speicheradressen und darin gespeicherte Werte. Über diese Daten kann dann gegebenenfalls ein geeigneter Hashwert oder dergleichen gebildet werden. Derart erfasste Daten, die auch als "Dataflow-Digest" bezeichnet werden, können seitens des Vergleichsbausteins als Ergebnisse oder Teilergebnisse des Ausführens des Nutzprogramms zu vorgegebenen Zeitpunkten während oder nach dem Ausführen des Nutzprogramms durch den ersten und den zweiten Prozessorkern verglichen werden. Sind die erfassten Daten bzw. die darüber gebildeten Hashwerte für einzelne der parallelen Programmausführungen nicht identisch, so deutet dies auf einen Fehler in mindestens einem der Programmabläufe hin. Insbesondere Hardwarefehler können auf diese Weise zuverlässig erkannt werden.

Während im Zusammenhang mit einer reinen Emulatorlösung sichergestellt werden muss, dass die Erfassung dieser Daten und gegebenenfalls die Berechnung des Hashwertes eindeutig jeweils einem Prozessorkern zugeordnet ist, kann dies vorliegend unterbleiben. Denn gemäß einer Ausführungsform ist es vorgesehen, dass die Funktionalität zum Erfassen der den Programmablauf beschreibenden Daten für den ersten Prozessorkern und den zweiten Prozessorkern in dem integrierten Schaltkreis hardwaremäßig jeweils separat implementiert sind.

Weiterhin kann eine im Zusammenhang mit einer reinen Emulatorlösung erforderlichen Analyse der verwendeten Rechnerarchitektur unterbleiben, um Rückwirkungen dieser Architektur auf spezifische Sicherheitsmechanismen zu beurteilen. Erfindungsgemäß wird die verwendete Hardware per Konfiguration in erforderlicher Weise angepasst.

Zusammenfassend liefert das Merkmal, wonach die Implementation des ersten Prozessorkerns in dem integrierten Schaltkreis hardwaremäßig von der Implementation des zweiten Prozessorkerns zumindest teilweise separiert ist, d. h. wonach einzelne Funktionalitäten der einzelnen Prozessorkerne jeweils separat in der verwendeten Hardware konfiguriert sind, im Wesentlichen funktional eindeutig getrennte Prozessorkerne, funktional eindeutig getrennte Speicher- und Datenzugriffsmechanismen sowie funktional eindeutig getrennte Überwachungsmechanismen in Bezug auf einen Programmablauf. Schließlich sind die erheblichen Performanzgewinne zu nennen.

Gemäß einer ersten bevorzugten Ausführungsform kann die Funktionalität des Mehrkernprozessors als Softcore in einem Field Programmable Gate Array (FPGA) konfiguriert sein. Dabei werden die einzelnen Prozessorkerne vorzugsweise als separate Einheiten in dem FPGA konfiguriert. Dies kann dadurch erreichet werden, dass für die einzelnen Prozessorkerne und ihre spezifischen Funktionalitäten, insbesondere mit Bezug auf die verwendeten Adress- und Datenstrukturen zum Abspeichern und Auslesen von Daten in oder aus dem jeweiligen Prozessorkern jeweils zugeordneten Speicherbereichen und mit Bezug auf die Erfassung eines vorstehend beschriebenen Dataflow-Digest, jeweils separate Beschreibungen in einer geeigneten Hardwarebeschreibungssprache, wie z. B. VHDL, vorliegen, auf deren Basis die jeweiligen Prozessorkerne dann in dem FPGA konfiguriert oder synthetisiert werden.

Gemäß einer alternativen Ausführungsform kann der Mehrkernprozessor als "hardcoded" CPU in einem Application-Specific Integrated Circuit (ASIC) implementiert werden. Gemäß dieser Ausführungsform liegen die einzelnen Prozessorkerne dann "hart codiert" als separate Einheiten vor.

Um eine Portierbarkeit der erfindungsgemäßen Anordnung, beispielsweise bei Obsoleszenz, zu gewährleisten, kann ein computerlesbares Speichermedium bereitgestellt werden, das eine Definition einer Implementation eines Mehrkernprozessors der vorstehend beschriebenen erfindungsgemäßen Anordnung umfasst. Die Definition erfolgt dabei mittels einer Hardwarebeschreibungssprache, insbesondere mittels der so genannten Very High Speed Integrated Circuit Hardware Description Language (VHDL). Alternative Hardwarebeschreibungssprachen können ebenfalls verwendet werden, wie z. B. Verilog. Es ist dann auf einfache Weise möglich, neue Hardware auf sehr niedriger Ebene derart zu konfigurieren, dass die Funktionalität des Mehrkernprozessors wiederhergestellt ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigen:
- Figur 1: eine bevorzugte Ausführungsform einer erfindungsgemäßen Anordnung mit einem integrierten Schaltkreis, in dem ein Mehrkernprozessor implementiert ist,
- Figur 2: ein computerlesbares Speichermedium, auf dem eine Definition des Mehrkernprozessors aus Fig. 1 mittels einer Hardwarebeschreibungssprache gespeichert ist, und

- Figur 3: Schritte einer bevorzugten Ausführungsform eines erfindungsgemäßen Verfahrens.

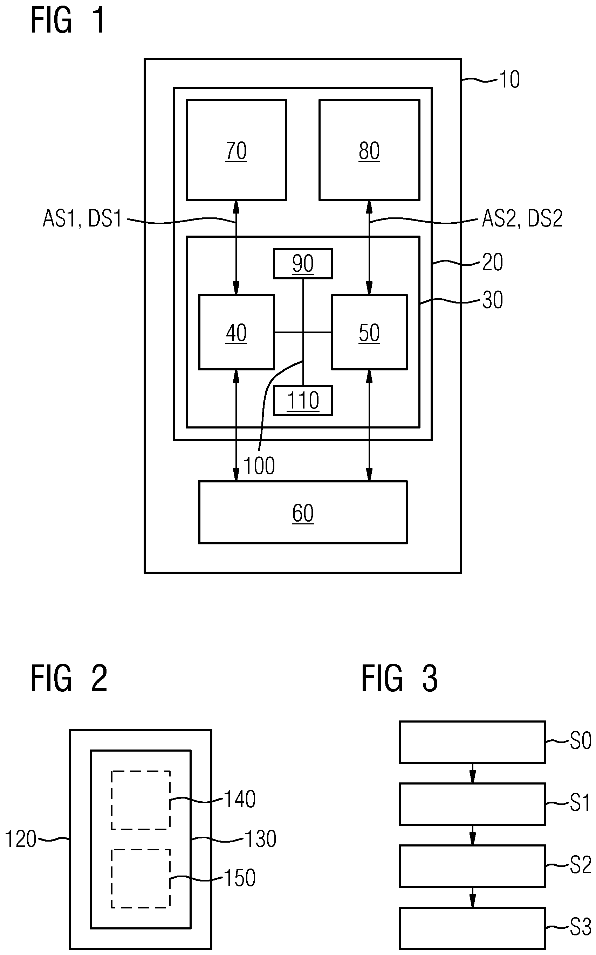

Fig. 1 zeigt eine Anordnung 10 zur redundanten Datenverarbeitung mit einem integrierten Schaltkreis 20. Die Anordnung 10 kann Teil einer Steuerung einer technischen Anlage sein, beispielsweise eines Stellwerks für den Eisenbahnverkehr.

In dem Schaltkreis 20 ist die Funktionalität eines Mehrkernprozessors 30 implementiert, der einen ersten Prozessorkern 40 und einen zweiten Prozessorkern 50 umfasst. Der Mehrkernprozessor 30 umfasst weitere Ressourcen, die von den beiden Prozessorkernen 40, 50 gemeinsam genutzt werden können, wie beispielsweise einen Cachespeicher 110 und einen Ein- und Ausgabespeicher 90 sowie Adress- und Datenleitungen 100.

Der Mehrkernprozessor 30 ist gemäß einer in einer Hardwarebeschreibungssprache, wie z. B. VHDL, angegebenen Definition 130 ausgebildet, d. h. im konkreten Fall in einem FPGA des integrierten Schaltkreises 20 konfiguriert. Dabei sind die beiden Prozessorkerne 40, 50 in dem FPGA derart konfiguriert, dass wesentliche, nachstehend genauer angegebene Funktionalitäten der Prozessorkerne 40, 50 für jeden Prozessorkern 40, 50 jeweils separat und prozessorkernspezifisch konfiguriert oder synthetisiert werden. Lediglich der besseren Verständlichkeit halber wird die hier exemplarisch beschriebene Ausführungsform auf nur zwei Prozessorkerne beschränkt. Grundsätzlich kann der Mehrkernprozessor mehr als zwei Prozessorkerne umfassen, die sich dann paarweise zueinander so verhalten können, wie dies nachfolgend für den ersten und den zweiten Prozessorkern 40, 50 beschrieben wird.

Fig. 2 zeigt schematisch ein computerlesbares Speichermedium 120, auf dem eine Definition 130 des Mehrkernprozessors 30 gespeichert ist. Die Definition ist in VHDL abgefasst und umfasst für jeden der Prozessorkerne 40, 50 spezifische Beschreibungsabschnitte 140, 150.

Jeder der Prozessorkerne 40, 50 ist eingerichtet, ein Nutzprogramm (nicht gezeigt), beispielweise ein Steuerprogramm für eine technische Anlage auszuführen. Ein paralleles redundantes Ausführen des Nutzprogramms auf dem ersten Prozessorkern 40 und dem zweiten Prozessorkern 50 kann dabei die Sicherheit der Anlage erhöhen. Dazu werden mittels eines Vergleichsbausteins 60 während und/oder nach dem Ausführen des Nutzprogramms Zwischenergebnisse bzw. Endergebnisse, die sich aus einer Ausführung des Nutzprogramms auf dem ersten Prozessorkern 40 und auf dem zweiten Prozessorkern jeweils ergeben, miteinander verglichen. Weicht ein Ergebnis, das sich durch Ausführen des Nutzprogramms auf dem ersten Prozessorkern 40 ergibt, von einem entsprechenden Ergebnis ab, welches sich durch Ausführen des Nutzprogramms auf dem zweiten Prozessorkern 50 ergibt, so kann dies als Fehler in der Programmausführung auf einem der Prozessorkerne 40, 50 erkannt werden. Ursache eines solchen Fehlers kann insbesondere ein Hardwarefehler sein.

Gemäß der nachstehend erläuterten Implementation oder Konfiguration des ersten und zweiten Prozessorkerns 40, 50 können dabei auch solche Hardwarefehler erkannt werden, welche auf Fehlern in Hardwarebestandteilen beruhen, welche von den beiden Prozessorkernen 40, 50 gemeinsam genutzt werden, wie z. B. die Speicherbereiche 90, 110 oder die Leitungen 100.

Der erste Prozessorkern 40 ist in dem FPGA derart konfiguriert, dass er zum Abspeichern und Auslesen von Daten in oder aus einem dem ersten Prozessorkern 40 zugeordneten ersten Speicherbereich 70 eine Adressstruktur AS1 verwendet, die sich von einer Adressstruktur AS2 unterscheidet, welche der zweite Prozessorkern 50 zum Abspeichern und Auslesen von Daten in oder aus einem dem zweiten Prozessorkern 50 zugeordneten zweiten Speicherbereich 80 verwendet. Der erste Prozessorkern 40 kann beispielsweise eine prozessorkernspezifisch verwürfelte Adressstruktur AS1 verwenden, die sich von einer ebenfalls prozessorkernspezifisch verwürfelten Adressstruktur AS2 unterscheidet, die der zweite Prozessorkern 50 verwendet.

Der erste Prozessorkern 40 ist weiterhin in dem FPGA derart konfiguriert, dass er zum Abspeichern und Auslesen von Daten in oder aus dem ersten Speicherbereich 70 eine Datenstruktur DS1 verwendet, die sich von einer Datenstruktur DS2 unterscheidet, welche der zweite Prozessorkern 50 zum Abspeichern und Auslesen von Daten in oder aus dem zweiten Speicherbereich 80 verwendet. Der erste Prozessorkern 40 kann beispielsweise ein zu speicherndes Datenwort im Vergleich zum zweiten Prozessorkern 50 um eine vorgegebene Anzahl von Bits verschieben.

Aufgrund der jeweils prozessorkernspezifisch verwürfelten Adressstruktur AS1, AS2 und/oder der prozessorkernspezifisch transformierten Datenstruktur DS1, DS2 zum Speichern von Datenwörtern können Hardwarefehler in von den Prozessorkernen 40, 50 gemeinsam genutzten Ressourcen 90, 100, 110 erkannt werden, da diese in den jeweiligen Prozessorkernen 40, 50 unterschiedliche Effekte haben, die sich dann spätestens in unterschiedlichen Zwischenergebnissen oder Ergebnissen bei der parallelen Ausführung des Nutzprogramms bemerkbar machen. Die Funktionalität zum Verwürfeln der Adressstruktur und zum Transformieren der Datenstruktur ist für jeden Prozessorkern 40, 50 in dem FPGA separat konfiguriert.

Der erste und der zweite Prozessorkern 40, 50 sind weiterhin eingerichtet, während des Ausführens des Nutzprogramms Daten zu erfassen, welche den Programmablauf beschreiben. Dies sind insbesondere besuchte Speicheradressen und darin gespeicherte Werte. Über diese erfassten Daten kann, zu Kompressionszwecken, ein Hashwert gebildet werden. Die Funktionalität zum Erfassen dieser Kontrolldaten ist für jeden Prozessorkern 40, 50 in dem FPGA separat konfiguriert. Da beide Prozessorkerne 40, 50 dasselbe Nutzprogramm ausführen, kann der Vergleichsbaustein 60 in dem Fall, dass beispielsweise ein von dem ersten Prozessorkern 40 erhaltenes erstes Zwischenergebnis in Form eines vorstehend erläuterten Hashwertes von einem Hashwert abweicht, welcher ein entsprechendes zweites Zwischenergebnis mit Bezug auf den zweiten Prozessorkern 50 darstellt, von einem Fehler während der Programmausführung im ersten oder zweiten Prozessorkern 40, 50 ausgehen.

Über einen Ein- und Ausgabespeicherbereich 90 kann eine Dateneingabe in und eine Datenausgabe durch Mehrkernprozessor 30 erfolgen. Dazu sind der erste Prozessorkern 40 und der zweite Prozessorkern 50 derart in dem FPGA konfiguriert, dass sie auf diesen Ein- und Ausgabespeicherbereich 90 gemäß einer von extern vorgegebenen, nicht transformierten oder verwürfelten Adress- und Datenstruktur zugreifen. Die in diesem Speicherbereich 90 gespeicherten Daten können dabei zusätzlich mittels einer Prüfsumme abgesichert werden. Die Prüfsumme kann dabei in dem jeweiligen Prozessorkern 40, 50 erstellt werden.

In Fig. 3 sind Schritte einer bevorzugten Ausführungsform eines Verfahrens zur redundanten Datenverarbeitung schematisch angegeben.

In einem vorgelagerten Schritt S0 wird ein computerlesbares Speichermedium 120 bereitgestellt, auf dem die Definition 130 eines vorstehend mit Bezug auf Fig. 1 beschriebenen Mehrkernprozessors 30 gespeichert ist. Die Definition ist mittels einer geeigneten Hardwarebeschreibungssprache, z. B. VHDL, abgefasst.

In Schritt S1 wird der Mehrkernprozessor 30 in einem FPGA eines integrierten Schaltkreises 20 gemäß der Definition 130 konfiguriert. Wie vorstehend mit Bezug auf Fig. 1 dargelegt, werden dabei wesentliche Funktionalitäten des ersten und zweiten Prozessorkerns 40, 50 jeweils prozessorkernspezifisch und separat in dem FPGA konfiguriert.

In Schritt S2 wird ein Nutzprogramms durch den ersten Prozessorkern 40 und den zweiten Prozessorkern 40 redundant parallel ausgeführt.

Zwischenergebnisse oder Endergebnisse, die sich aus der Ausführung des Nutzprogramms durch den ersten Prozessorkern 40 und aus der Ausführung des Nutzprogramms durch den zweiten Prozessorkern 50 ergeben, werden in Schritt S3 mittels des Vergleichsbausteins 60 verglichen.

Während der Ausführung des Nutzprogramms verwendet der erste Prozessorkern 40 zum Abspeichern und Auslesen von Daten in oder aus dem dem ersten Prozessorkern 40 zugeordneten ersten Speicherbereich 70 eine Adressstruktur AS1, die sich von einer Adressstruktur AS2 unterscheidet, welche der zweite Prozessorkern 50 zum Abspeichern und Auslesen von Daten in oder aus dem dem zweiten Prozessorkern 50 zugeordneten zweiten Speicherbereich 80 verwendet.

Weiterhin verwendet der erste Prozessorkern 40 in diesem Zusammenhang zum Abspeichern und Auslesen von Daten in oder aus dem ersten Speicherbereich 70 eine Datenstruktur DS1, die sich von einer Datenstruktur DS2 unterscheidet, welche der zweite Prozessorkern 50 zum Abspeichern und Auslesen von Daten in oder aus dem zweiten Speicherbereich 80 verwendet.

Zusammenfassend betrifft die vorliegende Erfindung eine Anordnung zur redundanten Datenverarbeitung, die einen integrierten Schaltkreis umfasst, in dem die Funktionalität eines Mehrkernprozessors implementiert ist. Prozessorkerne des Mehrkernprozessors sind jeweils ausgebildet, ein Nutzprogramm auszuführen, wobei Ergebnisse, die sich aus einer Ausführung des Nutzprogramms durch verschiedene der Prozessorkerne ergeben, mittels eines Vergleichsbausteins der Anordnung verglichen werden können. Die Prozessorkerne unterscheiden sich untereinander hinsichtlich einer Adress- oder Datenstruktur, die seitens eines Prozessorkerns jeweils zum Abspeichern und Auslesen von Daten in oder aus einem dem jeweiligen Prozessorkern zugeordneten Speicherbereich verwendet wird. Die einzelnen Prozessorkerne sind in dem integrierten Schaltkreis hardwaremäßig zumindest teilweise separat implementiert.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Anordnung zur redundanten Datenverarbeitung mit einem integrierten Schaltkreis, wobei in dem integrierten Schaltkreis die Funktionalität eines Mehrkernprozessors mit einer Mehrzahl von Prozessorkernen implementiert ist, wobei die Prozessorkerne jeweils ausgebildet sind, ein Nutzprogramm auszuführen,wobei die Anordnung einen Vergleichsbaustein umfasst, der eingerichtet ist, Ergebnisse zu vergleichen, die sich aus einer Ausführung des Nutzprogramms durch jeweils verschiedene der Prozessorkerne ergeben, wobei ein erster Prozessorkern und ein von dem ersten Prozessorkern verschiedener zweiter Prozessorkern der Mehrzahl der Prozessorkerne derart implementiert sind,
- dass der erste Prozessorkern zum Abspeichern und Auslesen von Daten in oder aus einem dem ersten Prozessorkern zugeordneten ersten Speicherbereich eine erste Adressstruktur (AS1) verwendet, die sich von einer zweiten Adressstruktur (AS2) unterscheidet, welche der zweite Prozessorkern zum Abspeichern und Auslesen von Daten in oder aus einem dem zweiten Prozessorkern zugeordneten zweiten Speicherbereich verwendet, wobei die zweite Adressstruktur (AS2) im Vergleich zur ersten Adressstruktur (AS1) transformiert, insbesondere verwürfelt, ist, und/oder
- dass der erste Prozessorkern zum Abspeichern und Auslesen von Daten in oder aus dem ersten Speicherbereich eine erste Datenstruktur (DS1) verwendet, die sich von einer zweiten Datenstruktur (DS2) unterscheidet, welche der zweite Prozessorkern zum Abspeichern und Auslesen von Daten in oder aus dem zweiten Speicherbereich verwendet, wobei die zweite Datenstruktur (DS2) im Vergleich zur ersten Datenstruktur (DS1) Datenwörter transformiert, insbesondere mittels Bitverschiebung oder anderer arithmetischer Operationen,
und wobei die Implementation des ersten Prozessorkerns in dem integrierten Schaltkreis hardwaremäßig von der Implementation des zweiten Prozessorkerns zumindest teilweise separiert ist, **dadurch gekennzeichnet, dass**
die Funktionalitäten des Transformierens der Adressstruktur und/oder der Datenstruktur für den ersten Prozessorkern und den zweiten Prozessorkern in dem integrierten Schaltkreis jeweils hardwaremäßig separat prozessorkernspezifisch implementiert sind, wobei keine Prüfung dahingehend, ob diese Funktionalitäten jeweils an den korrekten Prozessorkern gebunden sind, vorgesehen ist.

2. Anordnung (10) nach Anspruch 1, **dadurch gekennzeichnet, dass** die Funktionalität des Mehrkernprozessors (30) in dem integrierten Schaltkreis (20) derart implementiert ist, dass der erste Prozessorkern (40) und der zweite Prozessorkern (50) eingerichtet sind, Hardwareressourcen (90; 100; 110) des integrierten Schaltkreises (20) gemeinsam zu verwenden.

3. Anordnung (10) nach einem der vorhergehenden Ansprüche, **dadurch gekennzeichnet, dass** der erste Prozessorkern (40) und der zweite Prozessorkern (50) jeweils derart implementiert sind, dass diese eingerichtet sind, während der Laufzeit Daten zu erfassen, die einen Programmablauf beim Ausführen des Nutzprogramms beschreiben.

4. Anordnung (10) nach Anspruch 3, **dadurch gekennzeichnet, dass** die Funktionalität zum Erfassen der den Programmablauf beschreibenden Daten für den ersten Prozessorkern (40) und den zweiten Prozessorkern (50) in dem integrierten Schaltkreis (20) hardwaremäßig separat implementiert ist.

5. Anordnung (10) nach einem der vorhergehenden Ansprüche, **gekennzeichnet durch** einen Ein- und Ausgabespeicherbereich (90) zum Ermöglichen einer Dateneingabe in den Mehrkernprozessor (30) und einer Datenausgabe durch den Mehrkernprozessor (30), wobei der erste Prozessorkern (40) und der zweite Prozessorkern (50) derart implementiert sind, dass diese auf diesen Ein- und Ausgabespeicherbereich (90) gemäß einer vorgegebenen Adress- und Datenstruktur zugreifen.

6. Anordnung (10) nach einem der vorhergehenden Ansprüche, **dadurch gekennzeichnet, dass** die Funktionalität des Mehrkernprozessors (30) in einem Field Programmable Gate Array konfiguriert ist, wobei die Prozessorkerne (40; 50) als separate Einheiten in dem Field Programmable Gate Array konfiguriert sind.

7. Anordnung (10) nach einem der Ansprüche 1 bis 6, **dadurch gekennzeichnet, dass** der Mehrkernprozessor (30) in einem Application-Specific Integrated Circuit implementiert ist.

8. Verfahren zur redundanten Datenverarbeitung mittels einer Anordnung mit einem integrierten Schaltkreis, umfassend die Schritte:
Ausführen (S2) eines Nutzprogramms durch einen ersten Prozessorkern und einen zweiten, vom ersten Prozessorkern verschiedenen Prozessorkern eines durch den integrierten Schaltkreis implementierten Mehrkernprozessors; Vergleichen (S3) von Ergebnissen, die sich aus der Ausführung des Nutzprogramms durch den ersten Prozessorkern und aus der Ausführung des Nutzprogramms durch den zweiten Prozessorkern ergeben, wobei
- der erste Prozessorkern zum Abspeichern und Auslesen von Daten in oder aus einem dem ersten Prozessorkern zugeordneten ersten Speicherbereich eine erste Adressstruktur (AS1) verwendet, die sich von einer zweiten Adressstruktur (AS2) unterscheidet, welche der zweite Prozessorkern zum Abspeichern und Auslesen von Daten in oder aus einem dem zweiten Prozessorkern zugeordneten zweiten Speicherbereich verwendet, wobei die zweite Adressstruktur (AS2) im Vergleich zur ersten Adressstruktur (AS1) transformiert, insbesondere verwürfelt, ist,
und/oder
- der erste Prozessorkern zum Abspeichern und Auslesen von Daten in oder aus einem dem ersten Speicherbereich eine erste Datenstruktur (DS1) verwendet, die sich von einer zweiten Datenstruktur (DS2) unterscheidet, welche der zweite Prozessorkern zum Abspeichern und Auslesen von Daten in oder aus dem zweiten Speicherbereich verwendet, wobei
die zweite Datenstruktur (DS2) im Vergleich zur ersten Datenstruktur (DS1) Datenwörter transformiert, insbesondere mittels Bitverschiebung oder anderer arithmetischer Operationen, und wobei der erste Prozessorkern in dem integrierten Schaltkreis hardwaremäßig zumindest teilweise separat von dem zweiten Prozessorkern implementiert wird,
**dadurch gekennzeichnet, dass**
die Funktionalitäten des Transformierens der Adressstruktur und/oder der Datenstruktur für den ersten Prozessorkern und den zweiten Prozessorkern in dem integrierten Schaltkreis jeweils hardwaremäßig separat prozessorkernspezifisch implementiert sind, wobei keine Prüfung dahingehend, ob diese Funktionalitäten jeweils an den korrekten Prozessorkern gebunden sind, vorgesehen ist.

9. Computerlesbares Speichermedium (120), umfassend eine Definition (130) einer Implementation eines Mehrkernprozessors (30) der Anordnung (20) nach einem der Ansprüche 1 bis 7 mittels einer Hardwarebeschreibungssprache, insbesondere mittels der so genannten Very High Speed Integrated Circuit Hardware Description Language.

## Claims

1. Arrangement for redundant data processing with an integrated circuit, wherein the functionality of a multi-core processor with a plurality of processor cores is implemented in the integrated circuit, wherein the processor cores are each embodied to execute a useful program, wherein the arrangement comprises a comparison module, which is configured to compare results which emerge from execution of the useful program by different representatives of the processor cores in each case, wherein a first processor core and a second processor core different from the first processor core out of the plurality of processor cores are implemented such
- that the first processor core uses a first address structure (AS1) to store and read data items in or from a first memory area assigned to the first processor core that differs from a second address structure (AS2) used by the second processor core to store and read data items in or from a second memory area assigned to the second processor core, wherein the second address structure (AS2) is transformed, in particular scrambled, compared to the first address structure (AS1), and/or
- that the first processor core uses a first data structure (DS1) to store and read data items in or from the first memory area that differs from a second data structure (DS2) used by the second processor core to store and read data items in or from the second memory area, wherein the second data structure (DS2) transforms data words compared to the first data structure (DS1), in particular by means of bit shifting or other arithmetic operations,
and wherein the implementation of the first processor core in the integrated circuit is at least partially separated from the implementation of the second processor core in terms of hardware,
**characterised in that**
the functionality of transforming the address structure and/or the data structure for the first processor core and the second processor core are implemented separately in a processor-core-specific manner in the integrated circuit in terms of hardware in each case, wherein a check is thereby not provided as to whether these functionalities are in each case linked to the correct processor core.

2. Arrangement (10) according to claim 1, **characterised in that** the functionality of the multi-core processor (30) in the integrated circuit (20) is implemented such that the first processor core (40) and the second processor core (50) are configured to share hardware resources (90; 100; 110) of the integrated circuit (20).

3. Arrangement (10) according to one of the preceding claims, **characterised in that** the first processor core (40) and the second processor core (50) are in each case implemented such that they are configured to acquire data items during the runtime that describe a program sequence during execution of the useful program.

4. Arrangement (10) according to claim 3, **characterised in that** the functionality for acquiring the data items describing the program sequence is implemented separately for the first processor core (40) and the second processor core (50) in the integrated circuit (20) in terms of hardware.

5. Arrangement (10) according to one of the preceding claims, **characterised by** an input and output storage area (90) for enabling data input into the multi-core processor (30) and data output by the multi-core processor (30), wherein the first processor core (40) and the second processor core (50) are implemented such that they access this input and output storage area (90) according to a predetermined address and data structure.

6. Arrangement (10) according to one of the preceding claims, **characterised in that** the functionality of the multi-core processor (30) is configured in a field-programmable gate array, wherein the processor cores (40; 50) are configured as separate units in the field-programmable gate array.

7. Arrangement (10) according to one of claims 1 to 6, **characterised in that** the multi-core processor (30) is implemented in an application-specific integrated circuit.

8. Method for redundant data processing by means of an arrangement with an integrated circuit, comprising the steps:
execution (S2) of a useful program by a first processor core and a second processor core different from the first processor core of a multi-core processor implemented by the integrated circuit; comparison (S3) of results which emerge from execution of the useful program by the first processor core and from execution of the useful program by the second processor core, wherein
- the first processor core uses a first address structure (AS1) to store and read data items in or from a first memory area assigned to the first processor core that differs from a second address structure (AS2) used by the second processor core to store and read data items in or from a second memory area assigned to the second processor core, wherein the second address structure (AS2) is transformed, in particular scrambled, compared to the first address structure (AS1) and/or
- the first processor core uses a first data structure (DS1) to store and read data items in or from the first memory area that differs from a second data structure (DS2) used by the second processor core to store and read data items in or from the second memory area, wherein the second data structure (DS2) transforms data words compared to the first data structure (DS1), in particular by means of bit shifting or other arithmetic operations, and wherein the first processor core is implemented at least partially separately from the second processor core in the integrated circuit in terms of hardware,
**characterised in that**
the functionality of transforming the address structure and/or the data structure for the first processor core and the second processor core are implemented separately in a processor-core-specific manner in the integrated circuit in terms of hardware in each case, wherein a check is thereby not provided as to whether these functionalities are in each case linked to the correct processor core.

9. Computer-readable storage medium (120) comprising a definition (130) of an implementation of a multi-core processor (30) of the arrangement (20) according to one of claims 1 to 7 by means of a hardware description language, in particular by means of the so-called Very High-Speed Integrated Circuit Hardware Description Language.

## Revendications

1. Dispositif de traitement redondant de données comprenant un circuit intégré, dans lequel dans le circuit intégré la fonctionnalité d'un processeur à plusieurs noyaux ayant une pluralité de noyaux de processeurs est mise en oeuvre, dans lequel les noyaux de processeurs sont constitués chacun pour exécuter un programme utile, dans lequel le dispositif comprend un module de comparaison, qui est agencé pour comparer des résultats, qui proviennent d'une exécution du programme utile par respectivement divers des noyaux de processeurs, dans lequel un premier noyau de processeur et un deuxième noyau de processeur, différent du premier noyau de processeur, de la pluralité des noyaux de processeur sont mis en oeuvre de manière,
- à ce que le premier noyau de processeur utilise pour mettre en mémoire et lire des données dans une première partie de mémoire affectée au premier noyau de processeur une première structure (AS1) d'adresse, qui se distingue d'une deuxième structure (AS2) d'adresse que le deuxième noyau de processeur utilise pour mettre en mémoire et lire des données dans une deuxième partie de mémoire affectée au deuxième noyau de processeur, dans lequel la deuxième structure (AS2) d'adresse est par rapport à la première structure (AS1) d'adresse transformée, en étant en particulier embrouillée, et/ou
- en ce que le premier noyau de processeur utilise pour la mise en mémoire et la lecture de données dans la première partie de mémoire une première structure (DS1) de données, qui se distingue d'une deuxième structure (DS2) de données que le deuxième noyau de processeur utilise pour la mise en mémoire et la lecture de données dans la deuxième partie de mémoire, dans lequel la deuxième structure (DS2) de données transforme par rapport à la première structure (DS1) de données des mots de données en particulier au moyen d'un déplacement de bits ou d'autres opérations arithmétiques,
et, dans lequel la mise en oeuvre du premier noyau de processeur dans le circuit intégré est séparée au moins en partie, en matériel de la mise en oeuvre du deuxième noyau de processeur, **caractérisé en ce que**
les fonctionnalités de la transformation de la structure d'adresse et/ou de la structure de données pour le premier noyau de processeur et le deuxième noyau de processeur dans le circuit intégré sont mise en oeuvre respectivement spécifiquement à un noyau de processeur d'une manière séparée en matériel, un contrôle n'étant pas prévu sur le point de savoir si ces fonctionnalités sont reliées respectivement au noyau de processeur correct.

2. Dispositif (10) suivant la revendication 1, **caractérisé en ce que** la fonctionnalité du processeur (30) à plusieurs noyaux dans le circuit (20) intégré est mise en oeuvre de manière à ce que le premier noyau (40) de processeur et le deuxième noyau (50) de processeur soient agencés pour utiliser en commun des ressources (90 ; 100 ; 110) matérielles du circuit (20) intégré.

3. Dispositif (10) suivant l'une des revendications précédentes, **caractérisé en ce que** le premier noyau (40) de processeur et le deuxième noyau (50) de processeur sont chacun mis en oeuvre de manière à ce que ceux-ci soient agencés pour détecter pendant le temps d'exécution des données, qui décrivent un déroulement du programme lors de l'exécution du programme utile.

4. Dispositif (10) suivant la revendication 3, **caractérisé en ce que** la fonctionnalité de saisie des données décrivant le déroulement du programme est mise en oeuvre d'une manière séparée en matériel pour le premier noyau (40) de processeur et le deuxième noyau (50) de processeur dans le circuit (20) intégré.

5. Dispositif (10) suivant l'une des revendications précédentes, **caractérisé par** une partie (90) de mémoire d'entrée et de sortie pour permettre une entrée de données dans le processeur (30) à plusieurs noyaux et une sortie de données par le processeur (30) à plusieurs noyaux, dans lequel le premier noyau (40) de processeur et le deuxième noyau (50) de processeur sont mis en oeuvre de manière à ce que ceux-ci accèdent à cette partie (90) de mémoire d'entrée et de sortie suivant une structure d'adresse et de données donnée à l'avance.

6. Dispositif (10) suivant l'une des revendications précédentes, **caractérisé en ce que** la fonctionnalité du processeur (30) à plusieurs noyaux est configurée dans un Field Programmable Gate Array, dans lequel les noyaux (40 ; 50) de processeur sont configurés en unité distincte dans le Field Programmable Gate Array.

7. Dispositif (10) suivant l'une des revendications 1 à 6, **caractérisé en ce que** le processeur (30) à plusieurs noyaux est mis en oeuvre dans un Application-Specific Integrated Circuit.

8. Procédé de traitement redondant de données au moyen d'un dispositif ayant un circuit intégré comprenant les stades :
Exécution (S2) d'un programme utile par un premier noyau de processeur et par un deuxième noyau de processeur, différent du premier noyau de processeur, d'un processeur à plusieurs noyaux mis en oeuvre par le circuit intégré ; comparaison (S3) de résultats qui proviennent de l'exécution du programme utile par le premier noyau de processeur et de l'exécution du programme utile par le deuxième noyau de processeur, dans lequel
- le premier noyau de processeur utilise pour mettre en mémoire et lire des données dans une première partie de mémoire affectée au premier noyau de processeur une première structure (AS1) d'adresse, qui se distingue d'une deuxième structure (AS2) d'adresse que le deuxième noyau de processeur utilise pour mettre en mémoire et lire des données dans une deuxième partie de mémoire affectée au deuxième noyau de processeur, dans lequel la deuxième structure (AS2) d'adresse est par rapport à la première structure (AS1) d'adresse transformée, en étant en particulier embrouillée,
et/ou
- le premier noyau de processeur utilise pour la mise en mémoire et la lecture de données dans la première partie de mémoire une première structure (DS1) de données, qui se distingue d'une deuxième structure (DS2) de données que le deuxième noyau de processeur utilise pour la mise en mémoire et la lecture de données dans la deuxième partie de mémoire, dans lequel la deuxième structure (DS2) de données transforme par rapport à la première structure (DS1) de données des mots de données, en particulier au moyen d'un déplacement de bits ou d'autres opérations arithmétiques,
et, dans lequel
on met en oeuvre le premier noyau de processeur dans le circuit intégré en matériel au moins en partie d'une manière séparée du deuxième noyau de processeur,
**caractérisé, en ce que**
les fonctionnalités de la transformation de la structure d'adresse et/ou de la structure de données pour le premier noyau de processeur et le deuxième noyau de processeur dans le circuit intégré sont mise en oeuvre respectivement spécifiquement à un noyau de processeur d'une manière séparée en matériel, un contrôle n'étant pas prévu sur le point de savoir si ses fonctionnalités sont reliées respectivement au noyau de processeur correct.

9. Support (120) de mémoire, déchiffrable par ordinateur, comprenant une définition (130) d'une mise en oeuvre d'un processeur (30) à plusieurs noyaux du dispositif (20) suivant l'une des revendications 1 à 7 au moyen d'un langage de description matériel, en particulier au moyen de ce que l'on est convenu d'appeler le Very High Speed Integrated Circuit Hardware Drescription Language.
